# EUROPEAN PATENT SPECIFICATION

(11) **EP 2 399 281 B1**
(45) Date of publication and mention of the grant of the patent: **20.04.2016**
(21) Application number: 09799392.7
(22) Date of filing: 16.12.2009
(51) Int. Cl.: H01L 21/288, H01L 21/768, C25D 3/38, C25D 5/02, C25D 5/18, C25D 7/12, C25D 21/16

(54) **PROCESS FOR ELECTRODEPOSITION OF COPPER CHIP TO CHIP, CHIP TO WAFER AND WAFER TO WAFER INTERCONNECTS IN THROUGH-SILICON VIAS (TSV)**
VERFAHREN ZUR ELEKTROLYTISCHEN ABSCHEIDUNG VON KUPFER IN CHIP-ZU-CHIP, CHIP-ZU-WAFER UND WAFER-ZU-WAFER DURCHKONTAKTIERUNGEN DURCH SILIZIUM
PROCÉDÉ D'ÉLECTRODÉPOSITION D'INTERCONNEXIONS DE CUIVRE PUCE À PUCE, PUCE À TRANCHE ET TRANCHE À TRANCHE DANS DES TROUS D'INTERCONNEXIONS À TRAVERS LE SILICIUM (TSV)

(30) Priority: 17.02.2009 US 372113
(43) Date of publication of application: 28.12.2011
(73) Proprietor: Atotech Deutschland GmbH, 10553 Berlin (DE)
(72) Inventor: PREISSER, Robert, F., 721 19 Ammerbuch (DE)
(74) Representative: Wonnemann, Jörg
(86) International application number: PCT/IB2009/007793
(87) International publication number: WO 2010/094998

(56) References cited:
- WO-A1-2009/018581
- DE-A1- 4 344 387
- DE-A1- 19 545 231
- US-A1- 2006 216 921
- US-B1- 6 793 795
- JEN TSUNG LUO ET AL: "The effect of pulse-reverse plating time on blind micro via filling" IMPACT 2008. 3RD INTERNATIONAL MICROSYSTEMS, PACKAGING, ASSEMBLY & CIRCUITS TECHNOLOGY CONFERENCE IEEE PISCATAWAY, NJ, USA, 2008, pages 395-398, XP002582020 DOI: 10.1109/IMPACT.2008.4783895 ISBN: 978-1-4244-3622-4

## Description

### BACKGROUND

### 1. Field of the Invention

The invention relates to a process of electrolytically forming conductor structures from highly pure copper, more specifically to electrolytically forming conductor structures from highly pure copper in through-silicon vias (TSVs) when producing devices such as MEMS or semiconductor devices. Such TSVs are useful, e.g., in integrated circuits, in a stacked or 3D arrangement, in which the TSV provide electrical connection between the respective layers of the device, where the TSV have relatively large diameter, relatively great depth and a high aspect ratio.

### 2. Description of Related Art

The demands of fabricating cheaper, smaller and lighter electronic products offering better performance and increased functionality are continuously growing. The number of electronic device on a single chip is still rapidly increasing, and the ability of 2D layouts to accommodate these demands is being exceeded. According to industry roadmaps, integrated circuit (ID) chip size will be on the order of 30 nm by 2010. Such a small chip must carry more than 100 million transistors, which will require more than 100,000 I/Os for the next level packaging. As a result, chip and MEMS designers have turned to multilevel interconnection, which has been referred to as three-dimensional (3-D) stacking. 3-D wafer stacking represents a wafer level packaging technique in which specific components, such as logic, memory, sensors, A/D converters, etc., are fabricated on separate wafer platforms and then integrated onto a single wafer-scaled package using Through-Silicon Vias (TSVs) to provide electrical interconnection between elements of the 3-D stack. Because these devices are interconnected in the vertical axis, the electrical signal path between components becomes shorter, which results in lower parasitic losses, lower power consumption, and better system performance. Fabrication of TSVs by electrodeposition and other techniques has been reported. Although several conductive materials such as gold, polysilicon, and tin-lead (Sn-Pb) solder have been used as interconnect material, copper is the best and most preferred choice due to its higher electrical conductivity and electromigration resistance. For the purpose of depositing metal in deep through-holes, e.g., TSVs, electroplating is the most widely used process.

TSVs have been used for forming electrical connections between respective layers in a stacked or 3D arrangement in devices such as MEMS and semiconductor devices, but have suffered from various defects arising, at least partially, from difficulty in electroplating highly pure copper into the very large, high aspect ratio vias in the TSVs. For example, a typical TSV has an inner diameter in the range from about 1.5 to about 10 microns (although greater diameter TSVs may also be used), and a depth ranging from about 5 microns to about 450 microns or even greater depths (although wafer thicknesses of 5 to 25 microns, or of 100 microns, are more common in some applications). Future inner diameters are expected to be, for example, about 1 micron. The aspect ratio (depth/width) of the typical TSV may be about 3:1 or greater, or the aspect ratio may be about 5:1, at present, or the aspect ratio may be about 10:1, and the aspect ratio may be as high as 50:1, and future aspect ratios are expected to be commonly from about 10:1 to about 20:1. Attempts to electrodeposit high purity copper into such high aspect ratio TSVs have been partially successful, but have been plagued with problems arising from (a) internal stresses in the copper deposit which can result in wafer bending or deformation upon subsequent heating, (b) non-uniform deposits (i.e., grain boundaries, crystal structure defects, etc.), (c) inclusions of gases (voids) and/or electroplating bath liquid in the body of the electrodeposited copper, which can result in wafer bending and even explosive release of vapors, and (d) excess metal deposition at the inlet and outlet of the TSV through-hole.

Of these problems, the internal stress problem (a) can be the most troublesome, since it results in bending and deformation of the silicon substrate through which the TSV is formed, and this can cause failure of the entire 3D arrangement. This failure may not occur until after the entire device has been fabricated, resulting in loss of not only the failed silicon substrate, but of the whole device into which it has been incorporated at the time of failure.

US 2006/0216921 discloses a method of forming a through-silicon via (TSV) having an aspect ratio of 10:1, including forming a seed layer on a stack comprising a barrier layer and an insulating layer, and metallizing the TSV by electroplating of copper.

US 6 793 795 discloses a method of electroplating copper in damascene BEOL features, including the use of an insoluble anode and plating bath comprising Fe(II) and/or Fe(III) compounds.

The article "The Effect of Pulse-Reverse Plating Time on Blind Micro Via Filling" by Luo et al. discloses the use of a plating bath comprising a source of ferrous and/or ferric ions for the filling of vias in printed circuit boards.

### SUMMARY

In various of its embodiments, the present invention avoids the disadvantages of known processes and, more particularly, maximizes the electrodeposited filling of the TSVs with highly pure copper while at the same time the invention minimizes stress, avoids defects such as inclusions and voids, as well as other defects which have been found in prior art TSVs.

The invention relates to a process of electrolytically forming conductor structures from highly pure copper in through-silicon vias (TSVs) formed in silicon substrates such as silicon wafers used, e.g., in semiconductor devices. The process according to one embodiment of the present invention may be summarized as follows:
A process of electrodepositing high purity copper in a via in a silicon substrate to form a through-silicon-via (TSV), comprising:
   providing a silicon substrate containing at least one via, wherein the via includes an inner surface having an internal width dimension in the range from about 1.5 microns to about 30 microns, a depth from about 5 microns to about 450 microns and a depth:width aspect ratio of at least 3:1;
   optionally, forming a dielectric layer on the inner surface of the via;
   forming a barrier layer over the dielectric layer, or, if no dielectric layer is present, forming the barrier layer over the inner surface of the via, wherein the barrier layer is formed of or comprises a material which inhibits or provides an ability to the barrier layer to inhibit diffusion of copper into the silicon substrate;
   forming over the barrier layer a basic metal layer of sufficient thickness and coverage of the inner surface of the via to obtain sufficient conductance for subsequent electrolytic deposition of copper;
   immersing the silicon substrate into an electrolytic bath in an electrolytic copper plating system with the basic metal layer connected as a cathode, the system further comprising an insoluble dimensionally stable anode and a source of copper metal, wherein the electrolytic bath comprises an acid, a source of copper ions, a source of ferrous and/or ferric ions, and at least one additive for controlling physical-mechanical properties of deposited copper; and
   applying an electrical voltage between the insoluble dimensionally stable anode and the basic metal layer, so that a current flows therebetween for a time sufficient to electrodeposit high purity copper to form a TSV, wherein a Fe⁺²/Fe⁺³ redox system is established in the bath to provide additional copper ions to be electrodeposited by dissolving copper ions from the source of copper metal.

In one embodiment, the applying is effective to electrodeposit the high purity copper to completely fill the via, with no voids and no defects that inhibit its function in the finished device. In another embodiment, the applying is effective to electrodeposit the high purity copper to form a copper lining in the via of sufficient thickness to be capable of function as a TSV.

In one embodiment, the deposited high purity copper is either substantially free of internal stress or includes a level of internal stress that does not result in bending of the silicon substrate upon subsequent processing.

In one embodiment, the deposited copper is substantially free of voids and non-copper inclusions.

In one embodiment, the basic metal layer is formed over the barrier layer by one or more of an electroless plating process, a physical deposition process, a chemical vapor deposition process, or a plasma-enhanced chemical vapor deposition process.

In one embodiment, the basic metal layer has a thickness in the range from about 0.02 µm to about 0.5 µm.

In one embodiment, the basic metal layer comprises copper.

In one embodiment, the barrier layer comprises tantalum.

In one embodiment, the dielectric layer, when present, comprises silicon dioxide. In one embodiment, the barrier layer is a material which, in addition to functioning as a barrier layer, also is a dielectric material

In one embodiment, in the electrolytic bath, the acid is sulfuric acid at a concentration in the range from about 50 to about 350 g/l, the source of copper ions is copper sulfate pentahydrate at a concentration in the range from about 20 to about 250 g/l, the source of ferrous and/or ferric ions is ferrous sulfate heptahydrate and/or ferric sulfate nonahydrate at a concentration in the range from about 1 to about 120 g/l, and the at least one additive comprises one or more of a polymeric oxygen-containing compound, an organic sulfur compound, a thiourea compound and a polymeric phenazonium compound.

In one embodiment, the electrical voltage is applied in a pulse current or a pulse voltage.

In one embodiment, the electrical voltage is applied in a reverse pulse form with bipolar pulses.

### BRIEF DESCRIPTION OF THE DRAWINGS

**FIG. 1** is a schematic cross-sectional view of a 3D device including a substrate having mounted thereon two wafers including copper-filled TSVs electrodeposited by a process according to an embodiment of the present invention.
**FIGS. 2-9** are schematic cross-sectional views of steps in a process of forming TSVs in a wafer and mounting the wafer onto a substrate to form part of a 3D device such as that shown in FIG. 1 in accordance with an embodiment of the present invention.
**FIGS. 10-12** are schematic cross-sectional views of steps in a process of forming TSVs in a wafer and mounting the wafer onto a substrate to form part of a 3D device in accordance with another embodiment of the present invention.

### DETAILED DESCRIPTION

As used herein, the term "high purity copper", in reference to the copper electrodeposited in accordance with the present invention, refers to copper having a purity of at least 99%, and in one embodiment, to copper having a purity of at least 99.5%, and in another embodiment, to copper having a purity of at least 99.9%, and in yet another embodiment, to copper having a purity of at least 99.99%, as determined by standard chemical/instrumental analytical methods. In one embodiment, ICP-MS (inductively coupled plasma mass spectrometry) is used for analysis of the copper raw material. As will be understood, the purity of the copper deposit is primarily determined by the purity of the copper raw material, in addition to the herein disclosed process and system.

As used herein, the term "physical-mechanical properties", when applied to an electrodeposited metal layer in accordance with the present invention, refers to one or more of brightness, ductility, grain size, hardness, resistivity, contact resistance and reliability performance.

### FORMATION OF TSVs

Formation of vias with smooth sidewalls in the silicon substrate is an important step in the fabrication of a 3D device employing TSVs. As known, it is desirable to form a via at a high etch rate, with the via having smooth sidewalls, with a controllable sidewall angle and minimal mask undercut. A number of methods have been used, including wet etching, electrochemical etching, laser drilling and deep reactive ion etching (DRIE), and any one of them may be used in connection with the present invention. At present, it appears that DRIE is the most suitable process for forming TSVs having optimum features. DRIE creates almost vertical through-holes with relatively smooth surfaces at high etch rates. Thus, in one embodiment, DRIE is used to form the initial vias in which the TSVs are to be formed in the present invention.

TSVs may be created at various points in the manufacturing sequence - in the frontend wafer fab (before or after FEOL processes), or in the assembly and packaging facility after BEOL (before or after bonding). When viewed this way, the integration schemes under consideration can be classified as via-first or via-last, depending on when the vias are created. The size of the TSVs varies somewhat with the timing of the via formation, since vias created at different points in the process may be for different purposes or uses. The following are exemplary sizes of TSVs for various timings of TSV formation. In via-first before FEOL, the TSVs are relatively small, in the range from about 1 µm to about 5 µm diameter and from about 5 µm to about 50 µm depth, with high aspect ratios since these may be used for higher density interconnects. In via-first after FEOL, the TSVs are typically somewhat larger, from about 2 µm to about 20µm diameter and from about 10 µm to about 150 µm depths. In via-first applications, the number and density of TSVs may be very high. In via-last applications, processing in the frontend wafer fab is complete, and the vias generally penetrate the full stack of BEOL insulators and conductors in addition to the silicon substrate. In via-last before bonding, the largest TSVs are created, having diameters from about 5 µm to about 50 µm and depths from about 20 µm to about 400 µm. The interconnect density may be lower than for via-first applications, and may be, e.g., on the order of one hundred TSVs per die. Finally, in via-last after bonding, the TSVs may be smaller than via-last before bonding, but still may be larger than via-first, and may have a diameter in the range from about 2 to about 50µm and a depth in the range from about 10 to about 150µm. The foregoing diameters and depths are approximate and exemplary only, and are likely to change significantly in the future. The density of the TSVs for use in via-last after bonding may be about a hundred per die or higher. The via-last after bonding TSVs may be etched from the backside of a wafer that has already been thinned.

The sequence and timing of TSV formation and filling can be summarized as shown in the following table:

| | Process Steps | | | | |
|---|---|---|---|---|---|
| Via-First Before FEOL | Etch | Fill | FEOL + BEOL | Thinning add carrier | Bonding |
| Via-First After FEOL | FEOL | Etch | Fill | BEOL | Bonding Thinning |
| Via-Last Before Bond | FEOL + BEOL | Etch | Fill | Thinning add carrier | Bonding |
| Via-Last After Bond | FEOL + BEOL | Bonding | Thinning | Etch | Fill |

In accordance with one embodiment of the present invention, in the process sequences shown in this table, the "fill" step includes a process of filling the TSVs by electrodeposition using a redox system based on iron ions, as described in more detail in the following.

### FILLING TSVs BY ELECTRODEPOSITION

Complete, void-free and inclusion-free filling of TSVs with high purity copper is a very important step in the manufacture of devices incorporating TSVs. Incomplete metal filling, e.g., filing including void formation or inclusion formation, in the TSVs can lead to short-circuiting and will affect the electrical performance of the overall device. Grain size of the deposited copper is very important, since grain roughness can directly affect the electrical properties such as electrical resistivity, electromigration resistance, and internal stress in the TSV. As noted herein, the internal stress in the TSV can result in severe problems if it causes bending or deformation of the wafer or silicon substrate through which the TSV is formed. The stress can result from, e.g., rough grains or other defects, and the resulting deformation or bending can cause mechanical failure of the overall device. Thus, obtaining smooth, void-free, inclusion-free, fine grain metal deposition in the high aspect ratio TSVs is essential. The present invention provides such deposits of high purity copper.

Thus, according to the invention, a process of producing a highly pure copper fill in through-silicon vias (TSVs) formed, e.g., through semiconductor substrates (wafers), is provided and may be carried out.

The process, according to one embodiment of the invention, provides for electrodepositing high purity copper in a via in a silicon substrate to form a through-silicon-via (TSV), including the following steps (1)-(6), (noting that step (2) is optional, as described below):
(1) providing a silicon substrate containing at least one via, wherein the via includes an inner surface having an internal width dimension in the range from about 1.5 microns to about 30 microns, a depth from about 5 microns to about 450 microns and a depth:width aspect ratio of at least 3:1;
(2) optionally, forming a dielectric layer on the inner surface of the via;
(3) forming a barrier layer over the dielectric layer when present, or over the inner surface of the via, wherein the barrier layer is or comprises a material which inhibits diffusion of copper into the silicon substrate;
(4) forming over the barrier layer a basic metal layer of sufficient thickness and coverage of the inner surface of the via to obtain sufficient conductance for subsequent electrolytic deposition of copper;
(5) immersing the silicon substrate into an electrolytic bath in an electrolytic copper plating system with the basic metal layer connected as a cathode, the system further comprising an insoluble dimensionally stable anode and a source of copper metal, wherein the electrolytic bath comprises an acid, a source of copper ions, a source of ferrous and/or ferric ions, and at least one additive for controlling physical-mechanical properties of deposited copper; and
(6) applying an electrical voltage between the insoluble dimensionally stable anode and the basic metal layer, so that a current flows therebetween for a time sufficient to electrodeposit high purity copper to form a TSV, wherein a Fe⁺²/Fe⁺³ redox system is established in the bath to provide additional copper ions to be electrodeposited by dissolving copper ions from the source of copper metal.

In one embodiment, in step (1) of the process, the silicon substrate is provided with vias already formed. As noted above, the vias may be formed by any appropriate method, and are most often formed by reactive ion etching. At the point in the process at which the silicon substrate is provided, there may be hundreds or even thousands of vias already formed. This of course depends on what point in the process of vias are to be filled, and on other factors that will be readily recognized, such as the type of substrate, the application for which the substrate is to be used, etc. In general, the inner surface of the via will be formed of the silicon of the silicon substrate or, it may be formed of a reaction product resulting from the reactive ion etching. Thus for example, where the reactive ion etching has been carried out with a halogen present such as fluoride, the inner surface of the via may contain or consist of a silicon halide, such as silicon hexafluoride. Similarly, where the reactive ion etching has been carried out with oxygen present, the inner surface of the amount contain or consist of silicon dioxide. Thus, in such an embodiment, it would not be necessary to form a dielectric layer prior to proceeding with the subsequent steps of the process.

In one embodiment, the barrier layer is formed of a material, such as silicon nitride, which functions both as a barrier as described, and as a dielectric, in which case a separate dielectric layer need not be provided, and the step (2) above can be omitted. Of course, even when the barrier layer is or functions as a dielectric, it may be desirable to form a separate dielectric layer. In some embodiments, depending on the method by which the vias are formed, the vias may be formed with a dielectric layer in place. For example, when a gas is present in the via formation step which, when reacted with silicon, forms a dielectric silicon compound, the via may be formed with the dielectric layer in place.

In one embodiment, the step of applying is effective to electrodeposit the high purity copper to completely fill the via. Thus, in this embodiment, the step of applying an electrical voltage between the insoluble dimensionally stable anode and the basic metal layer, so that a current flows therebetween is carried out for a time sufficient to electrodeposit high purity copper to completely fill the via and to form a TSV having no inner cavity.

In one embodiment, the step of applying is effective to electrodeposit the high purity copper to form a copper lining in the via of sufficient thickness to be capable of function as a TSV. Thus, in this embodiment, the step of applying an electrical voltage between the insoluble dimensionally stable anode and the basic metal layer, so that a current flows therebetween is carried out only for a time sufficient to electrodeposit high purity copper to line the via with a layer of high purity copper sufficient to provide the needed conductance. In this embodiment, a TSV is formed having an inner cavity of whatever size remains after the via has been electroplated with sufficient copper.

In one embodiment, the deposited high purity copper is either substantially free of internal stress or includes a level of internal stress that does not result in bending of the silicon substrate upon subsequent processing. The presence of internal stress in the deposited high purity copper can result in bending or deformation of the substrate upon heating during subsequent process steps. Generally it is desirable that the high purity copper deposit be substantially free of internal stress. Since it may not be possible to completely avoid the presence of all internal stress, as long as the level of internal stress is low enough that there is no bending or deformation of the substrate during subsequent processing, then the level of stress is acceptable.

In one embodiment, the deposited copper is substantially free of voids and non-copper inclusions. It is very desirable that the deposited high purity copper be free of voids and non-copper inclusions. If voids are present, upon subsequent heating, the voids can cause deformation or, in some cases, can result in an explosive release of gas pressure. Both the deformation and the explosive release would result in an unsatisfactory situation. Any non-copper inclusions that might be present would result in a change in the conductivity of the copper, and would therefore interfere with the function of the TSV. For these reasons the high purity copper deposit should not include any substantial amount of non-copper inclusions.

In one embodiment, the basic metal layer is formed over the barrier layer by one or more of an electroless plating process, a physical deposition process, a chemical vapor deposition process, or a plasma-enhanced chemical vapor deposition process. The basic metal layer is applied to the surface of the via in order to provide a suitable conductive surface for the electrodeposition of the high purity copper. Thus it is very desirable that the basic metal layer be applied in a manner such that it will completely cover the inner surface of the via. For this reason, the chemical vapor deposition process and the plasma enhanced chemical vapor deposition process may be more preferred than a physical deposition process such as sputtering or an electroless plating process. However, both the physical deposition process and the electroless plating process are both suitable for use when properly applied, as will be understood.

The basic metal layer only needs to be thick enough to provide a conductive surface onto which the copper can be electrodeposited in the subsequent step. This thickness could be as low as a few nanometers, e.g., from about one to about 10 nm. However, in order to assure that a sufficient coverage has been obtained it may be desirable to apply a somewhat thicker layer of the basic metal. Thus, in one embodiment, the basic metal layer has a thickness in the range from about 0.01 micron to about 0.5 micron (about 10 nm to about 500 nm). In another embodiment, the basic metal layer has a thickness in the range from about 0.02 micron to about 0.25 micron, and in another embodiment the basic metal layer has a thickness in the range from about 0.05 micron to about 0.2 micron.

In one embodiment, the basic metal layer comprises copper. In another embodiment, the basic metal layer comprises high purity copper, in which the copper as substantially the same purity as the later deposited copper used to fill the via. The basic metal layer may comprise metals other than copper, on the condition that the metal provide sufficient coverage to the inner wall of the via and that it provide sufficient conductivity for the electrodeposited copper to adhere. Thus, for example, in various embodiments, the metals other than copper may include gold, silver, platinum, palladium, aluminum, or any of the transition metals. However, for reasons that will be readily apparent to the person of skill in the art, copper would be the most preferred metal for use in the basic metal layer.

As noted above, a barrier layer is formed in the via. The barrier layer is needed to prevent diffusion of the high purity copper of the TSV into the silicon of the substrate in which the TSV is located. The barrier layer may be made of any material that provides a sufficient barrier to diffusion of copper into the substrate. The barrier layer may be comprised of any appropriate materials that prevent diffusion of copper atoms into the substrate, or that enable the barrier layer as a whole to inhibit such diffusion. For example, the barrier layer may be comprised of one or more layers including materials, such as tantalum, tantalum nitride, titanium, titanium nitride and/or other suitable materials. Thus, the barrier layer is or comprises a material which inhibits the diffusion of copper into the substrate in which the TSV is formed, or the barrier layer contains a material or sub-layer which inhibits such diffusion of copper. In one embodiment, the barrier layer comprises tantalum. In one embodiment the barrier layer may be formed of a material such as silicon nitride or silicon carbide or a silicon carbide nitride. Typically, the barrier layer may be formed by advanced well-established sputter deposition techniques or by atomic layer deposition (ALD), depending on the device and process requirements.

In one embodiment, the dielectric layer is present and comprises silicon dioxide. In one embodiment, the dielectric layer is present and comprises silicon nitride. In this embodiment, the silicon nitride may provide dual duty, by forming both a barrier to copper migration and a dielectric layer to prevent current leakage. In such case, as noted, the barrier layer can function both as barrier and as dielectric to provide electrical insulation as well as a barrier to migration of the copper (or other metal used to fill the via).

Besides containing at least one copper ion source, preferably a copper salt with an inorganic or organic anion, for example copper sulfate, copper methane sulfonate, copper pyrophosphate, copper fluoroborate or copper sulfamate, the bath used for the copper deposition additionally contains at least one substance for increasing the electrical conductance of the bath, for example sulfuric acid, methane sulfonic acid, pyrophosphoric acid, fluoroboric acid or amidosulfuric acid.

In one embodiment, in the electrolytic bath:
the acid is concentrated sulfuric acid at a bath concentration in the range from about 50 to about 350 g/l, or from about 180 g/l to about 280 g/l, or from about 100 g/l to about 250 g/l, or from about 50 g/l to about 90 g/l,
the source of copper ions is copper sulfate pentahydrate (CuSO₄ 5 H₂O) at a bath concentration in the range from about 20 g/l to about 250 g/l, or from about 80 g/l to about 140 g/l, or from about 180 g/l to about 220 g/l.
the source of ferrous and/or ferric ions is ferrous sulfate heptahydrate and/or ferric sulfate nonahydrate at a bath concentration in the range from about 1 to about 120 g/l, or from about 1 g/l to about 20 g/l, and
the at least one additive comprises one or more of a polymeric oxygen-containing compound, an organic sulfur compound, a thiourea compound or a polymeric phenazonium compound.

Further details regarding the bath and the process are provided as follows.

The electroplating bath according to the invention contains at least one additive compound for controlling the physical-mechanical properties of the copper layers. Suitable additive compounds are, for example, polymeric oxygen-containing compounds, organic sulfur compounds, thiourea compounds, polymeric phenazonium compounds and polymeric nitrogen compounds, and mixtures or combinations of any two or more of any of these additive compounds.

Suitable, exemplary, polymeric oxygen-containing compounds include one or more of the following:
carboxymethyl cellulose
nonylphenol-polyglycol ether
octanediol-bis-(polyalkyleneglycol ether)
octanolpolyalkyleneglycol ether
oleic acid polyglycol ester
polyethylene-propyleneglycol copolymer
polyethyleneglycol
polyethyleneglycol-dimethylether
polyoxypropyleneglycol
polypropyleneglycol
polyvinyl alcohol
stearic acid polyglycol ester
stearyl alcohol polyglycol ether
β-naphtol polyglycol ether.
The polymeric oxygen-containing compounds additive compounds may be contained in the electrodeposition bath at a concentration in the range from about 0.005 g/l to about 20 g/l, and in one embodiment, from about 0.01 g/l to about 5 g/l.

Suitable, exemplary sulfur compounds with suitable functional groups for providing water solubility include one or more of the following:
3-(benzothiazolyl-2-thio)-propylsulfonic acid, sodium salt
3-mercaptopropane-1-sulfonic acid, sodium salt
ethylenedithiodipropylsulfonic acid, sodium salt
bis-(p-sulfophenyl)-disulfide, disodium salt
bis-(ω-sulfobutyl)-disulfide, disodium salt
bis-(ω-sulfohydroxypropyl)-disulfide, disodium salt
bis-(ω-sulfopropyl)-disulfide, disodium salt
bis-(ω-sulfopropyl)-sulfide, disodium salt
methyl-(ω-sulfopropyl)-disulfide, disodium salt
methyl-(ω-sulfopropyl)-trisulfide, disodium salt
O-ethyl-dithiocarboxylic acid-S-(ω-sulfopropyl)-ester, potassium salt thioglycolic acid
thiophosphoric acid-O-ethyl-bis-(ω-sulfopropyl)-ester, disodium salt
thiophosphoric acid-tris-(ω-sulfopropyl)-ester, trisodium salt.
The water-soluble organic sulfur additive compounds may be contained in the electrodeposition bath at a concentration in the range from about 0.0005 g/l to about 0.4 g/l, and in one embodiment, from about 0.001 g/l to about 0.15 g/l.

Suitable, exemplary thiourea-type compounds include one or more of the following:
thiourea
N-acetylthiourea
N-trifluoroacetylthiourea
N-ethylthiourea
N-cyanoacetylthiourea
N-allylthiourea
o-tolylthiourea
N,N'-butylene thiourea
thiazolidine thiol
4-thiazoline thiol
imidazolidine thiol (N,N'-ethylene thiourea)
4-methyl-2-pyrimidine thiol
2-thiouracil.

Suitable, exemplary phenazonium compounds include one or more of the following:
poly(6-methyl-7-dimethylamino-5-phenyl phenazonium sulfate)
poly(2-methyl-7-diethylamino-5-phenyl phenazonium chloride)
poly(2-methyl-7-dimethylamino-5-phenyl phenazonium sulfate)
poly(5-methyl-7-dimethylamino phenazonium acetate)
poly(2-methyl-7-anilino-5-phenyl phenazonium sulfate)
poly(2-methyl-7-dimethylamino phenazonium sulfate)
poly(7-methylamino-5-phenyl phenazonium acetate)
poly(7-ethylamino-2,5-diphenyl phenazonium chloride)
poly(2,8-dimethyl-7-diethylamino-5-p-tolyl-phenazonium chloride)
poly(2,5,8-triphenyl-7-dimethylamino phenazonium sulfate)
poly(2,8-dimethyl-7-amino-5-phenyl phenazonium sulfate)
poly(7-dimethylamino-5-phenyl phenazonium chloride).

Suitable, exemplary polymeric nitrogen-containing compounds include one or more of the following:
polyethylenimine
polyethylenimide
polyacrylic acid amide
polypropylenimine
polybutylenimine
N-methylpolyethylenimine
N-acetylpolyethylenimine
N-butylpolyethylenimine.

The thiourea-type compounds, polymeric phenazonium compounds and polymeric nitrogen containing compounds, as the additive compounds, may be used at a concentration in the range from about 0.0001 g/l to about 0.50 g/l, and in one embodiment, from about 0.0005 g/l to about 0.04 g/l.

As noted above, in order to achieve the effects, according to the invention, when using the claimed process, Fe(II) and/or Fe(III) compounds are contained in the bath. Suitable iron salts are both the iron(II)-sulfate-heptahydrate and iron(III)-sulfate-nonahydrate, from either or both of which the effective Fe²⁺/Fe³⁺ (Fe(II)/Fe(III)) redox system is formed after a short operational time. These salts are mainly suitable for aqueous, acidic copper baths. Other water-soluble iron salts may also be used, for example iron perchlorate. Salts which contain no (hard) complex formers are advantageous. Such complex formers may be biologically non-degradable or only may be degradable with some difficulty, thus such salts may create problems when disposing off-rinsing water (for example iron ammonium alum). Iron compounds having anions which lead to undesirable secondary reactions in the case of the copper deposition solution, such as chloride or nitrate for example, should not be used, if possible. In consequence, carboxylates of iron ions, such as acetate, propionate and benzoate, as well as the hexafluorosilicates, are also advantageous. Suitable systems employing the Fe²⁺/Fe³⁺ redox system are disclosed, for example, in U.S. Patent Nos. 5,976,341 and 6,099,711, which may be consulted for additional details on this system.

The concentration of the iron ion substance(s) may be as follows. In one embodiment, the iron ions are added as iron(II)-sulfate (FeSO₄ - 7 H₂O) at a concentration in the range from about 1 g/l to about 120 g/l, and in one embodiment from about 20 g/l to about 80 g/l. In one embodiment, the bath is prepared to initially contain from about 1 g/l to about 30 g/l ferrous ions (based on actual Fe²⁺ content, added as, e.g., ferrous sulfate heptahydrate) and from about 1 g/l to about 30 g/l ferric ions, in one embodiment, from about 2 to about 10 g/l, and in another embodiment, from about 3 to about 5 g/l (based on actual Fe³⁺ content, added as, e.g., ferric sulfate nonahydrate). In one embodiment, the bath is prepared to initially contain from about 2 g/l to about 20 g/l ferrous ions (based on actual Fe²⁺ content, added as, e.g., ferrous sulfate heptahydrate) and from 4 g/l to about 20 g/l ferric ions (based on actual Fe³⁺ content, added as, e.g., ferric sulfate nonahydrate). In one embodiment, the bath is prepared to initially contain from about 3 g/l to about 10 g/l ferrous ions (based on actual Fe²⁺ content, added as, e.g., ferrous sulfate heptahydrate) and from 5 g/l to about 20 g/l ferric ions (based on actual Fe³⁺ content, added as, e.g., ferric sulfate nonahydrate). As will be recognized, since there is a continuous cycling of the ferrous and ferric ions in the redox system, the actual concentrations of both ions may vary from the initial concentrations.

Since the copper ions consumed during the deposition from the deposition solution cannot be directly supplied by the anodes by dissolution when insoluble anodes are used, these copper ions are supplemented by chemically dissolving corresponding copper parts or copper-containing shaped bodies. In the redox system, copper ions are formed from the copper parts or shaped bodies in a redox reaction by the oxidizing effect of the Fe(III) compounds contained in the deposition solution, in which the Fe(III) ions are reduced to Fe(II) ions by the copper metal being oxidized to form Cu(II) ions in the electroplating bath, as described above. By means of this formation of the copper ions, the total concentration of the copper ions contained in the deposition solution is kept relatively constant, and the anodes remain the same uniform size. The deposition solution passes from the copper ion generator back again into the electrolyte chamber which is in contact with the wafers and the anodes. As will be recognized, the following reactions take place:

At the anodes:

Fe²⁺ → Fe³⁺ + e⁻

At the copper source:

Cu⁰ + 2 Fe³⁺ → Cu²⁺ + 2 Fe²⁺

At the cathode (e.g., at the semiconductor substrate):

Cu²⁺ + 2 e⁻ → Cu⁰ (main reaction)

Fe³⁺ + e⁻ → Fe²⁺ (minor reaction)

Thus, the system may be initialized with either or both a source of ferrous ion or a source of ferric ion, since the redox reaction interconverts these ions as the process proceeds. In one embodiment, the system is initialized with both a source of ferrous ions and a source of ferric ions. As a result of this process, the concentration of the copper ions in the deposition solution can be kept constant very easily, which helps to maintain uniformity of the copper deposit.

In one embodiment, the electrodeposition bath is substantially free of an added chloride, for example sodium chloride or hydrochloric acid. Chlorides have been used in similar electroplating baths, but in accordance with this embodiment of the present invention, the chloride is omitted. As used herein, when a possible bath component is omitted from the bath, or when a bath is referred to as being "free of" a component, this means that none of the component is intentionally added to the bath. Small amounts of such components may be present as impurities, but they are not added intentionally.

For the electrolytic copper deposition of the present invention, a voltage is applied between the semiconductor substrate and the anode, the voltage being so selected that an electric current of 0.05 amps per dm² (A/dm²) to 20 A/dm², in one embodiment, 0.2 A/dm² to 10 A/dm² and, in another embodiment, 0.5 A/dm² to 5 A/dm², where the current flows are expressed as amps per dm² of, e.g., semiconductor substrate surface, assuming that the plating is applied to the entire surface of the substrate.

In one embodiment, a pulse current or pulse voltage method is used. In the pulse current method, the current between the workpieces, polarized as the cathode, and the anodes, is set galvanostatically and modulated per unit time by suitable means. In the pulse voltage method, a voltage between the wafers, as cathodes, and the counter-electrodes, as anodes, is set potentiostatically, and the voltage is modulated per unit time so that a current is set which is variable per unit time.

The method, which is known as the reverse pulse method, in one embodiment is used with bipolar pulses. Those methods are especially suitable, in which the bipolar pulses comprise a sequence of cathodic pulses, lasting from 20 milliseconds to 100 milliseconds, and anodic pulses lasting from 0.3 milliseconds to 10 milliseconds. In one embodiment, the peak current of the anodic pulses is set to at least the same value as the peak current of the cathodic pulses. In one embodiment, the peak current of the anodic pulses is set two to three times as high as the peak current of the cathodic pulses.

In one embodiment, the electrical voltage is applied in a pulse current or a pulse voltage. In one embodiment, the electrical voltage is applied in a reverse pulse form with bipolar pulses. These processes are well known in the art, and detailed parameters for use with some embodiments of the present invention are described in more detail in the following.

In one embodiment, the electrical voltage is applied in a reverse pulse form with bipolar pulses including a forward current pulse and a reverse current pulse. In one embodiment, the duration of the reverse current pulse is adjusted to about 1 to about 20 milliseconds, and in another embodiment, the duration of the reverse current pulse is adjusted to about 2 to about 10 milliseconds. In one embodiment, the duration of the forward current pulse is adjusted to about 10 to about 200 milliseconds, and in another embodiment, the duration of the forward current pulse is adjusted to about 20 to about 100 milliseconds.

In one embodiment, peak current density of the forward current pulse at a work piece surface is adjusted to a maximum of about 15 amps per square decimeter (A/dm²), and in another embodiment, peak current density of the forward current pulse at a work piece surface is adjusted to a maximum of about 1.5 to about 8 A/dm². In one embodiment, the peak current density of the reverse current pulse at a work piece surface is adjusted to a maximum of about 60 A/dm², and in another embodiment, peak current density of the reverse current pulse at a work piece surface is adjusted to a maximum of about 30 to about 50 A/dm².

In one embodiment, a first current pulse is shifted with respect to a second current pulse by about 180°. A pause of suitable duration may be included between the first current pulse and the second current pulse. A suitable duration may range, for example, from about 1 millisecond to about 5 milliseconds, and in one embodiment is from about 2 milliseconds to about 4 milliseconds, and in one embodiment, is about 4 milliseconds.

In one embodiment, when compared to a copper electrodeposition system in which the redox system of the present invention is not used or not present, the redox system according to the present invention exhibits reduced consumption of organic additives. This unexpected benefit is believed to result from reduced oxidation of the organic additives at the anodes. In one embodiment, when compared to a copper electrodeposition system in which the redox system is not used or present, the redox system according to the present invention consumes only about 30% of the organic additives that would be consumed by the non-redox system.

In one embodiment, no soluble anodes made of copper are used as the anodes; rather, dimensionally stable, insoluble anodes are used. By using the dimensionally stable, insoluble anodes, a constant spacing can be set between the anodes and the wafers. The anodes are easily adaptable to the wafers in respect of their geometrical shape and, contrary to soluble anodes, they substantially do not change their geometrical external dimensions. In consequence, the spacing between the anodes and the wafers, which can influence the distribution of layer thickness on the surface of the wafers, remains constant. Without such constant spacing, variations in layer thickness and quality may result, causing non-uniform copper deposits.

To produce insoluble anodes, (inert) materials which are resistant to the electrolyte are used, such as stainless steel or lead for example. Anodes may be used which contain titanium or tantalum as the basic material, which may be coated with noble metals or oxides of the noble metals. Platinum, iridium or ruthenium, as well as the oxides or mixed oxides of these metals, may be used, for example, as the anode coating. Besides platinum, iridium and ruthenium, rhodium, palladium, osmium, silver and gold, or respectively the oxides and mixed oxides thereof, may also be used for the anode coating. A particularly high resistance to the electrolysis conditions may be obtained, for example, on a titanium anode having an iridium oxide surface, which was irradiated with fine particles, spherical bodies for example, and thereby compressed in a pore-free manner. In one embodiment, anodes may be used which are formed from noble metals, for example platinum, gold or rhodium or alloys of these metals. Other inert, electrically conductive materials, such as carbon (graphite), may also be used.

In one embodiment, the wafers are processed in a horizontal orientation for the copper deposition. Anodes in the deposition bath, also kept horizontal, are disposed directly opposite the wafers. Since dimensionally stable insoluble electrodes are employed, the distance between the anodes and the cathodic parts of the wafer or semiconductor device is maintained substantially constant.

The process according to the invention is especially suitable for filling vias to form TSVs in silicon substrates in, e.g., semiconductor devices, silicon wafers and MEMS devices.

In one embodiment, a dielectric layer is formed on the inner surface of the vias, during or subsequent to the step of etching to form the initial vias. The oxidation of silicon results in the formation of silicon dioxide, and this dielectric material may be employed to provide electrical isolation of the TSVs from the surrounding silicon substrate, chip or wafer. The dielectric layer may be formed by any suitable process. In another embodiment, a silicon dioxide layer is formed, for example, by a TEOS process or by an oxidation of the silicon sidewalls of the via. Suitable methods for formation of a layer of such dielectric materials are known in the art and may be selected by the person of skill in the art as needed.

Since the TSVs will be filled with high purity copper in accordance with the present invention, suitable measures should be taken to prevent the diffusion of copper atoms into the silicon substrate situated adjacent to the TSVs. Thus, in one embodiment, a barrier layer is formed on the inner sidewalls of the TSV, in order to provide a barrier to diffusion of the later-deposited copper into the silicon of the substrate through which the TSV is formed. In one embodiment, the barrier layer is a tantalum-containing material capable of reducing and/or eliminating diffusion of copper therethrough. In one embodiment, in order to produce a diffusion barrier between the copper layer and the silicon substrate, therefore, a nitride layer (tantalum nitride layer for example) is formed, for example, by a sputtering process. Suitable methods for formation of a layer of such barrier materials are known in the art and may be selected by the person of skill in the art as needed.

In order to permit the copper to be electrolytically deposited on the dielectric surface of the barrier layer, the barrier layer may be made electrically conductive by deposition of a suitable base metal layer over the barrier layer. In one embodiment, the base metal layer is subsequently applied, which forms an electrically conductive base for the subsequent electrolytic metallization. In one embodiment, a full-surface layer having a thickness in the range from about 0.02 µm to about 0.3 µm, is applied as the basic metal layer. In one embodiment, the base metal layer is applied by a physical metal deposition process and/or by a CVD process and/or by a PECVD process. In addition or alternatively, a plating process may also be used, for example an electroless metal deposition process. For example, a basic metal layer formed from copper may be deposited. Other conductive layers, usually metal layers, may also be suitable. Such conductive layers may include, for example, a metal such as tungsten, silver, gold, platinum, zinc, tin or any other metal or silicide known for use as a seed layer for electrodeposition of copper onto a non-conductive substrate.

After the base metal layer has been formed, the copper fill for the TSV is electrolytically deposited according to the above-described process.

In one embodiment, the process of the present invention is integrated into a semiconductor fabrication process, and includes
lithography and masking for the etch process,
DRIE or laser etching for creation of the TSV,
formation of a dielectric isolation layer by an oxidation,
formation of a barrier layer by physical vapor deposition, thermal and/or CVD,
formation of a base metal or seed layer by an appropriate method, such as a copper electroless process,
copper electrodeposition filling of the TSV as described in detail herein,
appropriate treatment such as CMP and cleaning, to complete formation of the filled TSV.

The wafer or semiconductor device may then be processed using standard technology, such as CMOS, and later subjected to processes such as thinning, lithography, solder bump, dicing and then die-to-die, die-to-wafer, wafer-to-wafer or other appropriate 3D construction by various known methods. In general, manufacturing aspects relating to TSVs may include via formation, metallization, wafer thinning, alignment, and bonding.

The following non-limiting examples are provided to illustrate an embodiment of the present invention and to facilitate understanding of the invention, but are not intended to limit the scope of the invention, which is defined by the claims appended hereto.

### Example 1:

To produce a TSV filled with a high purity copper deposit, a wafer is provided with vias having a diameter of about 10 microns and a depth of about 50 microns. The vias are initially coated with a dielectric layer of silicon dioxide formed by high temperature oxidation of the inner sidewalls of the vias. The dielectric layer on the inner sidewalls of the vias is next coated with a diffusion barrier layer formed from tantalum nitride applied by sputtering. Subsequently, the diffusion barrier layer is coated with a copper base metal layer by a sputtering process, in which the copper base metal layer has a thickness of about 0.1 micron. The wafer is then immersed in a copper deposition bath described below in which the wafer is connected as a cathode and an insoluble anode is included. The via is filled with high purity copper by electrodeposition from the bath having the following ingredients, to form the TSVs in accordance with the present invention:

| | |
|---|---|
| H₂SO₄, 98% by wt. | 130 g/l |
| CuSO₄ · 5 H₂O | 70 g/l |
| FeSO₄ · 7 H₂O | 15 g/l and |
| polyethylene glycol | 8 g/l |

in water.
The high purity copper is electrodeposited under the following conditions:
cathodic current density 4 A/dm²
circulation of the bath 5 l/min
at room temperature.
Pulsed current is applied with the parameters shown in the table below.

### Example 2:

Copper stress in TSVs deposited by different plating methods using the above-disclosed bath in accordance with the invention and either using a similar bath without the added Fe²⁺/Fe³⁺ ions or using a similar bath but with a soluble copper anode, in which pulsed current is applied with the parameters shown in the table below:

| Examples | I_{forward}/Iᵣₑᵥₑᵣₛₑ in A/dm² | Pulse in milliseconds Forward- / Reverse-Pulse | Pulse-gap in milliseconds | Phase shift in degrees |
|---|---|---|---|---|
| 1 and 2 | 6/40 | 72/4 | 4 | 180 |

| Electrodeposition Method | Stress |
|---|---|
| Soluble Copper Anode: | 163.2 ± 34.3 MPa |
| (prior art) | |
| Soluble Copper Anode w/ Fe²⁺/Fe³⁺ redox | 113.4 ± 40.1 MPa |
| (prior art) | |
| Inert Anode w/ Cu/Cu²⁺ / Fe²⁺/Fe³⁺ redox | 66.9 ± 9.8 MPa |
| (present invention) | |

The internal stress is measured as deposited without a post-annealing step. The measurement is via wafer warpage and bow (LASER measurement). The equipment used was a KLA-TENCOR FLX-2320 thin film stress measurement system, copper film thickness 1 micron, wafer thickness 750 micron.

As is clearly shown by the data from Example 2, when TSVs are filled in accordance with the present invention, significantly lower and significantly more consistent stress levels are obtained in the TSVs.

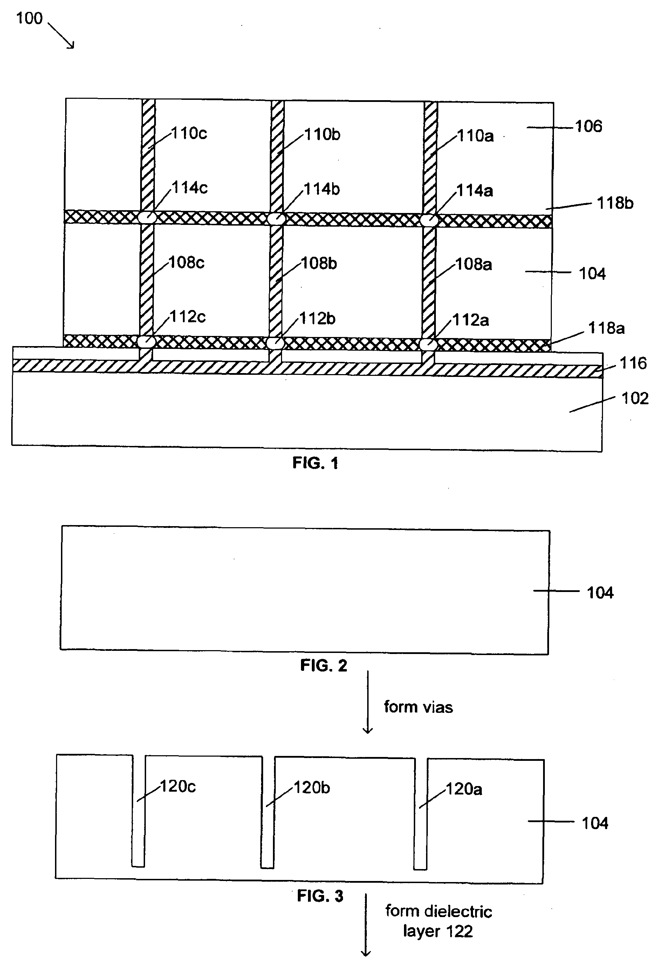

**FIG. 1** is a schematic cross-sectional view of a 3D device 100 including a substrate 102 having mounted thereon two wafers 104 and 106, including copper-filled TSVs 108a, 108b, 108c, 110a, 110b and 110c, in which the TSVs have been electrodeposited by a process according to an embodiment of the present invention. The substrate 102 may be any suitable substrate, such as a chip, a wafer or some other substrate upon which one or more chips or wafers is to be attached to form a 3D device such as the 3D device 100 depicted in **FIG.** 1. As shown in **FIG. 1****,** the 3D device 100 further includes solder bumps 112a, 112b, 112c, 114a, 114b and 114c, by which the respective filled TSVs 108a, 108b, 108c, 110a, 110b and 110c are electrically interconnected to each other and to electrical wiring 116 in the substrate 102. Finally, as shown in **FIG. 1****,** the 3D device 100 further includes under fill material 118 between the wafer 104 and the substrate 102 and between the wafer 104 and the wafer 106. It is noted that **FIG. 1** is a highly schematic depiction of a 3D device, and for the sake of clarity and simple explanation omits the various functional elements that would be present in the various elements of the 3D device, so as to more clearly depict the important elements of the 3D device which can be formed by a process including various embodiments of the present invention.

**FIGS. 2-9** are schematic cross-sectional views of steps in a process of forming TSVs in a wafer and mounting the wafer onto a substrate to form part of a 3D device such as the 3D device 100 shown in **FIG. 1****,** in accordance with an embodiment of the present invention. The process depicted in **FIGS. 2-9** is presented schematically and, as will be understood, may be carried out in the appropriate selected order as described above, with respect to the "via first" or "via last", before or after FEOL and before or after bonding.

**FIG. 2** depicts a silicon substrate, such as a wafer, chip or other silicon substrate which may be used, e.g., in a semiconductor device, through which TSVs are to be formed.

In the next step of a process according to an embodiment of the present invention, TSVs are formed in the silicon substrate 104. As disclosed above, any suitable method of forming TSVs may be used, and in one embodiment, the method is DRIE. This formation is indicated by the arrow leading from **FIG. 2** to **FIG. 3****.**

**FIG. 3** depicts the silicon substrate of **FIG. 2** after the TSVs 120a, 120b and 120c have been formed through most of the thickness of the silicon substrate 104. It is noted that, for simplicity, only three TSVs 120a-120c are depicted in **FIGS. 1-8****,** but as disclosed above, a given wafer or semiconductor device may contain hundreds or thousands of such TSVs. It is further noted that, for simplicity, the TSVs 120a-120c in **FIG. 3****,** and in all of the **FIGS. 1 and 3****-9,** are shown as having vertical, parallel sidewalls; this is for purposes of ease of illustration and is not intended to depict a required situation. As is known, while the sidewalls may be vertical or substantially vertical, in some embodiments, the sidewalls in TSVs generally taper slightly from top to bottom, i.e., from the opening of the via to the bottom of the via, so that the diameter at the bottom is slightly smaller than the diameter at the top opening or mouth of the via.

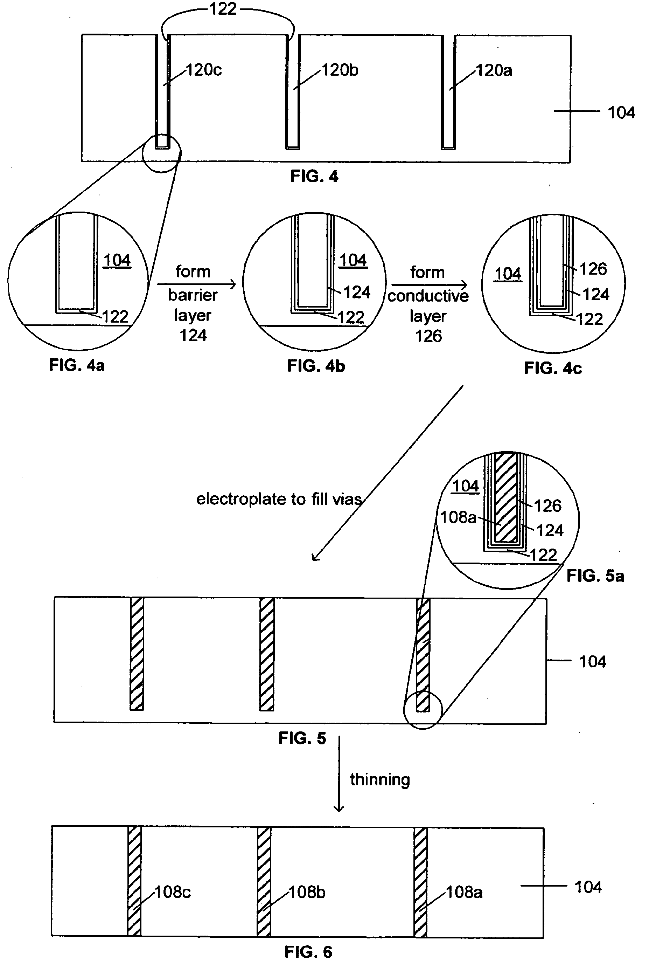

Subsequent to formation of the TSVs 120a-120c, in the next step of a process according to an embodiment of the present invention, on the entire inside surface of the sidewalls of each TSV 120 there optionally may be deposited a dielectric layer 122, as shown in **FIGS. 4** and **4a****.** Due to the scale of **FIG. 4****,** an expanded view of a portion of the TSV 120c and the subsequently applied layers are shown in **FIGS. 4a, 4b and 4c****.** As described above, the dielectric layer 122 is provided as an electrical insulation layer between the subsequently formed conductive fill of the TSV and the adjacent silicon substrate 104. The entire inner surface of each TSV 120a-120c should be covered with the dielectric layer 122. As will be understood, the relative proportions of the layers and the substrate 104 are not to scale. As noted above, the dielectric layer is optional, and in an appropriate embodiment, the step illustrated in **FIG. 4a** can be omitted, e.g., when the barrier layer subsequently formed also functions as a dielectric.

Next a barrier layer 124 is deposited or formed over the dielectric layer 122, as shown in **FIG. 4b****.** The barrier layer may be formed of a material such as, for example, tantalum (Ta), tantalum/tungsten (TaW) or tantalum nitride (TaN), or other material known to function as a barrier to copper migration. The barrier layer 124 is provided in order to prevent migration of copper into the adjacent silicon substrate 104. The barrier layer may be deposited by any appropriate method known in the art for deposition of such a layer.

Following formation of the barrier layer 124, as shown in **FIG. 4c**, in the next step of a process according to an embodiment of the present invention, a conductive base metal or seed layer 126 is deposited on the surface of the barrier layer 124 lining the TSVs 120a-120c. As described above, the base metal layer 126 may be any appropriate conductive metal layer, and in one embodiment is copper, and in another embodiment is high-purity copper. The base metal layer 126 may be deposited by any appropriate method known in the art for deposition of such a layer. The base metal layer 126 provides a conductive surface upon which the electrodeposition of the TSV fill metal can take place.

The next step of a process according to an embodiment of the present invention, each of the TSVs 120a-120c are filled with high purity copper by an electrodeposition process as described above, to form the filled TSVs 108a-108c, as depicted in **FIG. 5****.** The high purity copper is electrodeposited using the redox system described above, such that the copper is deposited on the base metal layer 126, and the high purity copper completely fills the TSVs with essentially no voids or inclusions, in accordance with an embodiment of the present invention.

It is noted that, in **FIGS. 1** and **5****-9,** although the dielectric layer 122, the barrier layer 124 and the conductive layer 126 are not clearly shown due to the scale of the drawings, they are deemed to be present, having been formed as described above, and shown in **FIGS. 4a, 4b** and **4c****.**

**FIGS. 6-9** schematically depict certain steps in a process of attaching a silicon substrate 104 containing the filled TSVs 108a-108c to the substrate 102. Also, at this time, any needed removal of the variously deposited layers from other surfaces of the wafer may be carried out. For example, the copper electrodeposition may cover the entire upper surface of the wafer, and may be removed, e.g., by chemical-mechanical polishing (CMP). Suitable methods for removing excess material deposited in the course of carrying out the processes described herein may be selected as needed by those of skill in the art. These layers and steps for removing them are not shown in the drawings, but will be readily understood and appreciated by the skilled person.

In **FIG. 6****,** the wafer containing the newly formed TSVs 108a-108c has been thinned, thus exposing the lower or bottom end of the TSVs 108a-108c to enable electrical connection of the TSVs 108a-108c in subsequent steps. The thinning may be carried out by any known method for thinning semiconductor wafers, chips, etc.

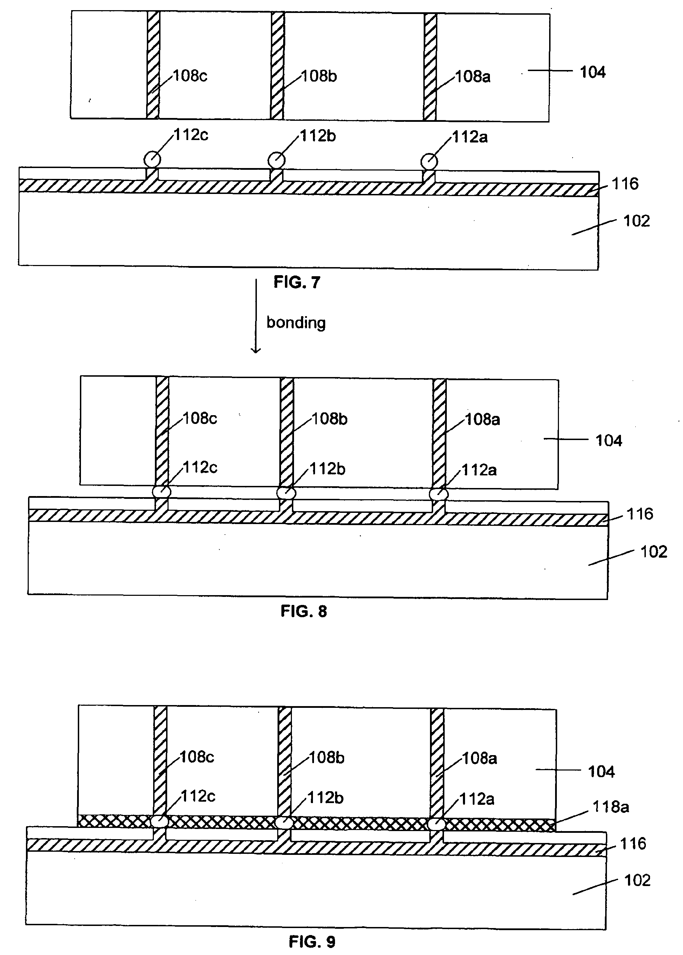

In **FIG. 7****,** the silicon substrate 104 containing the filled TSVs 108a-108c is positioned above or adjacent to the substrate 102. As shown, the substrate 102 includes the electrical wiring 116, similar to that shown in **FIG. 1****.** As shown, in **FIG. 7****,** solder beads or balls 112a, 112b and 112c have been placed in locations at which the TSVs 108a-108c will contact exposed portions of the electrical wiring 116. The solder beads 112a-112c may be formed of any suitable material, such as tin-lead solder or any other known solder material used for making such attachments, and may be deposited according to any known method.

As depicted in **FIG. 8****,** the next step is contacting each of the TSVs 108a-108c to the solder beads 112a-112c, which are in turn in contact with the electrical wiring 116 in the substrate 102, and thereby to create an electrical connection between the respective TSVs 108a-108c to the electrical wiring 116 via the respective solder beads 112a-112c. The contacting may be by any known method.

As depicted in **FIG. 9****,** the underfill material 118a can be added to fill the or any space remaining between the silicon substrate 104 and the substrate 102. In one embodiment, the underfill material is placed following the step of contacting the TSVs to the solder beads, and in another embodiment, the underfill material 118a is applied to the substrate prior to the contacting. As will be understood, the underfill material 118a may be applied before or after the solder beads.

It is noted that, in an embodiment in which the TSV is formed after bonding in a "via last" approach, the step of etching may form TSVs that penetrate through the entire thickness of the silicon substrate (not shown). In some such cases, a lower layer to which the wafer has already been bonded may act as an etch stop layer.

In another embodiment, in some applications in which the TSVs are very large, i.e., having a diameter from about 20 µm to about 50 µm, it may not be necessary to entirely fill the TSV, but instead as long as a thick lining is formed, the high conductivity of the copper may be sufficient to provide the electrical conductivity required of the TSVs.

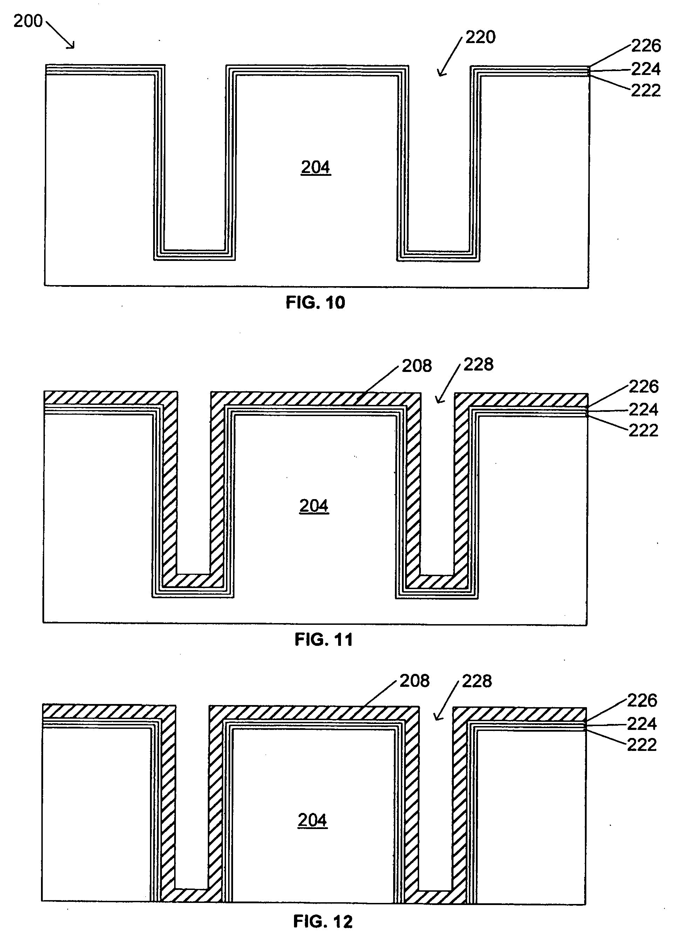

**FIGS. 10-12** are schematic cross-sectional views of steps in a process of forming TSVs in a wafer and mounting the wafer onto a substrate to form part of a 3D device in accordance with another embodiment of the present invention.

**FIG. 10** depicts the wafer into which a TSV is being formed at a point in the process corresponding to FIG. 4c, after the via 220 has been formed, a dielectric layer 222, a barrier layer 224 and a base metal conductive layer 226 have been deposited on the sidewalls in sequence as described with the embodiment of **FIGS. 4, 4a, 4b and 4c****,** and in which the materials deposited and methods therefore are the same as have been described above.

The next step of the process according to this embodiment of the invention, in the wafer 200, each of the vias 220 are lined, but are not completely filled, with a relatively thick and uniform layer of highly pure copper by an electrodeposition process as described above, to form the lined TSVs 208, as depicted in **FIG. 11****.** The highly pure copper is electrodeposited using the redox system described above, such that the copper is deposited on the base metal layer 226, and the highly pure copper completely lines the inner walls of the TSVs with a thick layer of the highly pure copper. The layer of high purity copper itself contains essentially no voids or inclusions, in accordance with an embodiment of the present invention. The layer has a thickness which, when coupled with the relatively large size of the TSV, provides adequate conductivity without requiring the TSV 208 to be completely filled. Thus, in this embodiment, as schematically depicted in **FIG. 11****,** the TSV 208 includes one large, central opening 228, in that the via 220 has not been completely filled but instead is covered with a uniformly thick layer of the high purity copper by the process in accordance with this embodiment of the invention.

Following formation of the TSV 208, the wafer 200 is then thinned to provide the wafer at the stage shown in **FIG. 12****.** In **FIG. 12****,** the wafer containing the newly formed TSVs 208 has been thinned, thus exposing the lower or bottom end of the TSVs 208 to enable electrical connection of the TSVs 208 in subsequent steps. The thinning may be carried out by any known method for thinning semiconductor wafers, chips, etc.

It is noted that in the embodiment shown in **FIG. 12****,** the layers including the dielectric layer 222, the barrier layer 224, the base metal layer 226 and the high purity copper layer 208 have not yet been removed from the upper surface of the wafer 200. These layers would also be present in the embodiment of the invention described with respect to **FIGS. 2-9****,** but in describing that embodiment, the step of removing these layers was not specifically described. Such step would have been carried out subsequent to the step of electroplating with high purity copper in accordance with the invention, and had already been completed at the point in the process depicted in **FIG. 5****.** In that embodiment, and in the embodiment described with respect to **FIG. 12****,** the copper layer can simply be removed, e.g., by CMP, or it can be patterned to create an electrical circuit on that surface of the wafer. In the latter case, where the patterned electrical circuit is desired, the pattern may be formed by a photoresist process prior to the step of electroplating with high purity copper. While it is also possible to carry out the pattern formation steps subsequent to the step of electroplating with high purity copper, it is considered to be more efficient to form the pattern, e.g., by a photoresist process, prior to the step of electroplating with high purity copper.

It is noted that, throughout the specification and claims, the numerical limits of the disclosed ranges and ratios may be combined, and are deemed to include all intervening values. Thus, for example, where ranges of 1-100 and 10-50 are specifically disclosed, the ranges of 1-10, 1-50, 10-100 and 50-100 are deemed to be within the scope of the disclosure, as are the intervening integral values. Furthermore, all numerical values are deemed to be preceded by the modifier "about", whether or not this term is specifically stated. Finally, all possible combinations of disclosed elements and components are deemed to be within the scope of the disclosure, whether or not specifically mentioned. That is, terms such as "in one embodiment" are deemed to disclose unambiguously to the skilled person that such embodiments may be combined with any and all other embodiments disclosed in the present specification.

While the principles of the invention have been explained in relation to certain particular embodiments, and are provided for purposes of illustration, it is to be understood that various modifications thereof will become apparent to those skilled in the art upon reading the specification. Therefore, it is to be understood that the invention disclosed herein is intended to cover such modifications as fall within the scope of the appended claims. The scope of the invention is limited only by the scope of the appended claims.

## Claims

1. A process of electrodepositing high purity copper in a via in a silicon substrate to form a through-silicon-via (TSV), comprising:
providing a silicon substrate containing at least one via, wherein the via includes an inner surface having an internal width dimension in the range from 1.5 microns to 30 microns, a depth from 5 microns to 450 microns and a depth:width aspect ratio of at least 3:1;
optionally, forming a dielectric layer on the inner surface of the via;
forming a barrier layer over the inner surface of the via or over the dielectric layer when present, wherein the barrier layer inhibits diffusion of copper into the silicon substrate;
forming over the barrier layer a basic metal layer of sufficient thickness and coverage of the inner surface of the via to obtain sufficient conductance for subsequent electrolytic deposition of copper;
immersing the silicon substrate into an electrolytic bath in an electrolytic copper plating system with the basic metal layer connected as a cathode, the system further comprising an insoluble dimensionally stable anode and a source of copper metal, wherein the electrolytic bath comprises an acid, a source of copper ions, a source of ferrous and/or ferric ions, and at least one additive for controlling physical-mechanical properties of deposited copper; and
applying an electrical voltage between the insoluble dimensionally stable anode and the basic metal layer, so that a current flows therebetween for a time sufficient to electrodeposit high purity copper to form a TSV, wherein a Fe⁺²/Fe⁺³ redox system is established in the bath to provide additional copper ions to be electrodeposited by dissolving copper ions from the source of copper metal.

2. The process of claim 1 wherein the applying is effective to electrodeposit the high purity copper to completely fill the via.

3. The process of any one of claims 1 -2 wherein the basic metal layer is formed over the barrier layer by one or more of an electroless plating process, a physical deposition process, a chemical vapor deposition process, or a plasma-enhanced chemical vapor deposition process.

4. The process of any one of claims 1-3 wherein the basic metal layer has a thickness in the range from 0.02 microns to 0.5 microns.

5. The process of any one of claims 1-4 wherein the basic metal layer comprises copper.

6. The process of any one of claims 1-5 wherein the barrier layer comprises tantalum.

7. The process of any one of claims 1-6 wherein the dielectric layer comprises silicon dioxide.

8. The process of any one of claims 1-7 wherein in the electrolytic bath, the acid is sulfuric acid at a concentration in the range from 50 to 350 g/l,
the source of copper ions is copper sulfate pentahydrate at a concentration in the range from 20 to 250 g/l,
the source of ferrous and/or ferric ions is ferrous sulfate heptahydrate and/or ferric sulfate nonahydrate at a concentration in the range from 1 to 120 g/l, and
the at least one additive comprises one or more of a polymeric oxygen-containing compound, an organic sulfur compound, a thiourea compound and a polymeric phenazonium compound.

9. The process of any one of claims 1-8 wherein the electrical voltage is applied in a pulse current or a pulse voltage.

10. The process of claim 9 wherein the electrical voltage is applied in a reverse pulse form with bipolar pulses including a forward current pulse and a reverse current pulse.

11. The process of claim 10 wherein the duration of the reverse current pulse is adjusted to 1 to 20 milliseconds.

12. The process of any one of claims 10 or 11 wherein the duration of the forward current pulse is adjusted to 10 to 200 milliseconds.

13. The process of any one of claims 10-12 wherein peak current density of the forward current pulse at a work piece surface is adjusted to a maximum of 15 A/dm².

14. The process of any one of claims 10-13 wherein the peak current density of the reverse current pulse at a work piece surface is adjusted to a maximum of 60 A/dm².

15. The process of any one of claims 10-14 wherein a first current pulse is shifted with respect to a second current pulse by 180°.

## Patentansprüche

1. Verfahren zur elektrolytischen Abscheidung von hochreinem Kupfer in einer Durchkontaktierung in einem Siliciumsubstrat zum Bilden einer Silicium-Durchkontaktierung (TSV), umfassend:
Bereitstellen eines Siliciumsubstrats mit mindestens einer Durchkontaktierung, wobei die Durchkontaktierung eine Innenfläche mit einer inneren Breitenabmessung im Bereich von 1,5 Mikrometer bis 30 Mikrometer, eine Tiefe von 5 Mikrometer bis 450 Mikrometer und ein Aspektverhältnis von Tiefe zu Breite von mindestens 3:1 umfasst,
optionales Bilden einer dielektrischen Schicht auf der Innenfläche der Durchkontaktierung;
Bilden einer Sperrschicht über der Innenfläche der Durchkontaktierung oder über der dielektrischen Schicht, falls vorhanden, wobei die Sperrschicht Diffusion von Kupfer in das Siliciumsubstrat hemmt;
Bilden über der Sperrschicht einer Grundmetallschicht von ausreichender Dicke und ausreichendem Bedeckungsgrad der Innenfläche der Durchkontaktierung, um ausreichende Konduktanz zur anschließenden elektrolytischen Abscheidung von Kupfer zu erhalten;
Eintauchen des Siliciumsubstrats in ein elektrolytisches Bad in einem elektrolytischen Kupferplattierungssystem, wobei die Grundmetallschicht als eine Kathode angeschlossen ist, das System ferner ein unlösliche maßbeständige Anode und eine Quelle von Kupfermetall umfasst, wobei das elektrolytische Bad eine Säure, eine Quelle von Kupfer-Ionen, eine Quelle von Eisen(II)- und/oder Eisen(III)-Ionen und mindestens en Additiv zum Steuern von physikalisch-mechanischen Eigenschaften des abgeschiedenen Kupfers umfasst; und
Anlegen einer elektrischen Spannung zwischen die unlösliche maßbeständige Anode und die Grundmetallschicht, so dass für eine Zeit, die zum elektrolytischen Abscheiden von hochreinem Kupfer zur Bildung einer TSV reicht, ein Strom dazwischen fließt, wobei ein Fe⁺²/Fe⁺³-Redoxsystem im Bad hergestellt wird, um zusätzliche Kupfer-Ionen bereitzustellen, die durch Auflösen von KupferIonen aus der Quelle von Kupfermetall elektrolytisch abgeschieden werden sollen.

2. Verfahren nach Anspruch 1, wobei das Anlegen zum elektrolytischen Abscheiden des hochreinen Kupfers zum vollständigen Füllen der Durchkontaktierung wirksam ist.

3. Verfahren nach einem der Ansprüche 1 bis 2, wobei die Grundmetallschicht durch eines oder mehrere von einem Verfahren zur stromlosen Plattierung, einem Verfahren zur physikalischen Abscheidung, einem Verfahren zur chemischen Dampfabscheidung oder einem Verfahren zur plasmagestützten chemischen Dampfabscheidung über der Sperrschicht gebildet wird.

4. Verfahren nach einem der Ansprüche 1 bis 3, wobei die Grundmetallschicht eine Dicke im Bereich von 0,02 Mikrometer bis 0,5 Mikrometer aufweist.

5. Verfahren nach einem der Ansprüche 1 bis 4, wobei die Grundmetallschicht Kupfer umfasst.

6. Verfahren nach einem der Ansprüche 1 bis 5, wobei die Sperrschicht Tantal umfasst.

7. Verfahren nach einem der Ansprüche 1 bis 6, wobei die dielektrische Schicht Siliciumdioxid umfasst.

8. Verfahren nach einem der Ansprüche 1 bis 7, wobei im elektrolytischen Bad die Säure Schwefelsäure in einer Konzentration im Bereich von 50 bis 350 g/l ist,
die Quelle von Kupfer-Ionen Kupfersulfat-Pentahydrat in einer Konzentration im Bereich von 20 bis 250 g/l ist,
die Quelle von Eisen(II)- und/oder Eisen(III)-Ionen Eisen(II)-sulfat-Heptahydrat und/oder Eisen(III)-sulfat-Nonahydrat in einer Konzentration im Bereich von 1 bis 120 g/l ist,
und
das mindestens eine Additiv eine oder mehrere von einer sauerstoffhaltigen Polymerverbindung, einer organischen Schwefelverbindung, einer Thioharnstoffverbindung und einer polymeren Phenazoniumverbindung umfasst.

9. Verfahren nach einem der Ansprüche 1 bis 8, wobei die elektrische Spannung in einem Impulsstrom oder einer Impulsspannung angelegt wird.

10. Verfahren nach Anspruch 9, wobei die elektrische Spannung in Form eines Rückwärtsimpulses angelegt wird, wobei bipolare Impulse einen Vorwärtsstromimpuls und einen Rückwärtsstromimpuls umfassen.

11. Verfahren nach Anspruch 10, wobei die Dauer des Rückwärtsstromimpulses auf 1 bis 20 Millisekunden eingestellt wird.

12. Verfahren nach Anspruch 10 oder 11, wobei die Dauer des Vorwärtsstromimpulses auf 10 bis 200 Millisekunden eingestellt wird.

13. Verfahren nach einem der Ansprüche 10 bis 12, wobei die Spitzenstromdichte des Vorwärtsstromimpulses an einer Werkstückfläche auf ein Maximum von 15 A/dm² eingestellt wird.

14. Verfahren nach einem der Ansprüche 10 bis 13, wobei die Spitzenstromdichte des Rückwärtsstromimpulses an einer Werkstückfläche auf ein Maximum von 60 A/dm² eingestellt wird.

15. Verfahren nach einem der Ansprüche 10 bis 14, wobei ein erster Stromimpuls in Bezug auf einen zweiten Stromimpuls um 180° verschoben wird.

## Revendications

1. Procédé de dépôt électrique de cuivre de haute pureté dans un passage ménagé dans un substrat en silicium de manière à former un passage traversant le silicium ("through-silicon-via" - TSV), le procédé comportant les étapes qui consistent à :
prévoir un substrat de silicium traversé par au moins un passage, le passage comprenant une surface intérieure présentant une dimension de largeur intérieure de l'ordre d'environ 1,5 micromètres à 30 micromètres, une profondeur d'environ 5 micromètres à 450 micromètres et un rapport entre la profondeur et la largeur d'au moins 3:1,
facultativement, former une couche diélectrique sur la surface intérieure du passage,
former une couche de barrière sur la surface intérieure du passage ou au-dessus de la couche diélectrique éventuellement présente, la couche de barrière empêchant la diffusion du cuivre dans le substrat de silicium,
former au-dessus de la couche de barrière une couche de métal de base d'une épaisseur suffisante et couvrant la surface intérieure du passage suffisamment pour obtenir une conductance suffisante pour le dépôt électrolytique ultérieur de cuivre,
immerger le substrat en silicium dans un bain d'électrolyse d'un système de placage électrolytique de cuivre, la couche de métal de base étant raccordée en cathode, le système comprenant en outre une anode insoluble de dimension stable et une source de cuivre métallique, le bain d'électrolyse comprenant un acide, une source d'ions de cuivre, une source d'ions ferreux et/ou d'ions ferriques et au moins un additif qui contrôle les propriétés physicomécaniques du cuivre déposé et
appliquer une tension électrique entre l'anode insoluble de dimension stable et la couche de métal de base de manière à ce qu'un courant s'écoule entre elles pendant une durée suffisante pour déposer par électrolyse du cuivre de haute pureté de manière à former un TSV, un système redox Fe⁺²/Fe⁺³ étant établi dans le bain de manière à fournir des ions supplémentaires de cuivre à déposer par électrolyse en dissolvant des ions cuivre de la source de cuivre métallique.

2. Procédé selon la revendication 1, dans lequel l'application est efficace pour déposer par électrolyse le cuivre de haute pureté jusqu'à remplir complètement le passage.

3. Procédé selon l'une quelconque des revendications 1 et 2, dans lequel la couche de métal de base est formée au-dessus de la couche de barrière par une opération de placage non électrolytique, une opération de dépôt physique, une opération de dépôt chimique de vapeur et/ou une opération de dépôt chimique de vapeur renforcé par plasma.

4. Procédé selon l'une quelconque des revendications 1 à 3, dans lequel la couche de métal de base présente une épaisseur comprise dans la plage de 0,02 micromètre à 0,5 micromètre.

5. Procédé selon l'une quelconque des revendications 1 à 4, dans lequel la couche de métal de base contient du cuivre.

6. Procédé selon l'une quelconque des revendications 1 à 5, dans lequel la couche de barrière comprend du tantale.

7. Procédé selon l'une quelconque des revendications 1 à 6, dans lequel la couche diélectrique comprend du dioxyde de silicium.

8. Procédé selon l'une quelconque des revendications 1 à 7, dans lequel, dans le bain d'électrolyse, l'acide est l'acide sulfurique à une concentration comprise entre 50 et 350 g/l,
la source d'ions cuivre est du sulfate de cuivre pentahydraté à une concentration comprise entre 20 et 250 g/l,
la source d'ions ferreux et/ou d'ions ferriques est le sulfate ferreux heptahydraté et/ou le sulfate ferrique nonahydraté, à une concentration comprise entre 1 et 120 g/l et
le ou les additifs comprennent un composé polymère contenant de l'oxygène, un composé organique du soufre, un composé de thiourée et/ou un composé polymère de phénazonium.

9. Procédé selon l'une quelconque des revendications 1 à 8, dans lequel la tension électrique est appliquée sous la forme d'un courant pulsé ou d'une tension pulsée.

10. Procédé selon la revendication 9, dans lequel la tension électrique est appliquée sous la forme d'un courant pulsé en impulsions bipolaires comprenant une impulsion de courant avant et une impulsion de courant inversé.

11. Procédé selon la revendication 10, dans lequel la durée de l'impulsion de courant inversé est ajustée entre 1 et 20 millisecondes.

12. Procédé selon l'une quelconque des revendications 10 ou 11, dans lequel la durée de l'impulsion de courant avant est ajustée entre 10 et 200 millisecondes.

13. Procédé selon l'une quelconque des revendications 10 à 12, dans lequel la pointe de densité de courant de l'impulsion de courant avant à la surface de la pièce traitée est réglée à un maximum de 15 A/dm².

14. Procédé selon l'une quelconque des revendications 10 à 13, dans lequel la pointe de densité de courant de l'impulsion de courant inverse à la surface de la pièce traitée est réglée à un maximum de 60 A/dm².

15. Procédé selon l'une quelconque des revendications 10 à 14, dans lequel une première impulsion de courant est déphasée de 180° par rapport à une deuxième impulsion de courant.
